# EUROPÄISCHE PATENTANMELDUNG

(11) **EP 0 582 211 A1**
(43) Veröffentlichungstag der Anmeldung: **09.02.1994**
(21) Anmeldenummer: 93112117.2
(22) Anmeldetag: 29.07.1993
(51) Int. Cl.: H01G 9/20

(54) **Photolelektrochemische Zelle**

(30) Priorität: 03.08.1992 DE 4225576
(71) Anmelder: ABB PATENT GmbH, D-68309 Mannheim (DE)
(72) Erfinder: Flatz, Josef, Dr., D-69483 Waldmichelbach (DE); Knödler, Reinhard, Dr., D-69207 Sandhausen (DE); Lüthi, Hans K., CH-5452 Oberrohrdorf (CH); Sopka, Jörg, Dr., D-68723 Schwetzingen (DE)
(74) Vertreter: Rupprecht, Klaus, Dipl.-Ing.

(57) **Zusammenfassung**

Die Erfindung betrifft eine photoelektrochemische Zelle (10), insbesondere Solarzelle, mit wenigstens einer Elektrode (16), die auf einer Glasplatte (12) angeordnet ist, welche Glasplatte (12) die Frontseite (13) bildet, und mit einer elektrisch nichtleitenden Rückwand (20) versehen ist, wobei zwischen der Glasplatte (12) und der Elektrode (16) eine transparente, elektrisch leitende Oxidschicht (14) angeordnet ist, die Elektrode (16) als Anode dient und als porige mit anorganischem Farbstoff durchsetzte Schicht aus Titandioxid ausgebildet ist, auf der rückwärtigen Oberfläche der Anode eine als Kathode (18) dienende Gegenelektrode anliegt und die Rückwand biegesteif ausgebildet ist.

## Beschreibung

Die Erfindung betrifft eine photoelektrochemische Zelle, insbesondere Solarzelle, mit wenigstens einer Elektrode, die auf einer Glasplatte angeordnet ist, welche Glasplatte die Frontseite bildet, und mit einer elektrisch nicht leitenden Rückwand.

Aus der EP 03 33 641 A1 ist bekannt, daß die Grenzschichten zwischen Elektrolyten und Halbleitern photoelektrochemische Eigenschaften zeigen, welche sich ähnlich verhalten, wie die Sperrschichten bei Halbleiter-Metall-Kontakten. Halbleiter mit geringem Abstand zwischen Leitungs- und Valenzband, bei denen die Ladungsträger des Halbleiters selbst mit Licht photoelektrisch angeregt werden, wie beispielsweise bei Silizium, Gallium-Arsenid, Cadmiumsulfid werden unter Lichtbestrahlung bei Verwendung von Elektrolyten photokorrosiv zersetzt. Die Empfindlichkeit, d.h. die photochemische Ausbeute für sichtbares Licht, also für Sonnenlicht, kann erhöht werden, wenn auf die Oberfläche des Halbleiters sogenannte Chromophore, auch Sensibilisatoren oder Dyes genannt, chemisch an- oder eingelagert werden. Die beiden Funktionen der Lichtabsorption und der Ladungsträgertrennung sind bei diesen photoelektrochemischen Systemen getrennt. Die Lichtabsorption wird vom Chromophor im Oberflächenbereich übernommen und die Trennung der Ladungsträger erfolgt an der Grenzschicht Halbleiter-Chromophor. Als Elektrolyt für derartige photoelektrochemische Zellen sind beispielsweise Jodid, Bromid oder Hydrochinon oder andere Redoxsysteme geeignet. Als Elektrode werden Metalloxidhalbleiter verwendet, insbesondere die Oxide der Übergangsmetalle sowie die Elemente der dritten Hauptgruppe und der vierten, fünften und sechsten Nebengruppe des Periodensystems. Daneben sind auch Mischoxide oder Oxidgemische dieser Metalle geeignet. Als besonders vorteilhaft hat sich die Verwendung von Titandioxid als Elektrodenmaterial erwiesen. Zellen mit Elektroden aus Titandioxid haben jedoch einen Wirkungsgrad, der unter dem Grenzwert für einen wirtschaftlichen Betrieb liegt.

Ausgehend von diesem Stand der Technik ist es daher Aufgabe der Erfindung, eine photoelektrochemische Zelle der eingangs genannten Art zu schaffen, deren Wirkungsgrad gegenüber dem Stand der Technik verbessert ist.

Erfindungsgemäß wird diese Aufgabe durch die kennzeichnenden Merkmale des Patentanspruchs 1 gelöst. Danach ist vorgesehen, daß zwischen der Glasplatte und der Elektrode eine transparente elektrisch leitende Oxidschicht angeordnet ist, daß die Elektrode als Anode dient und als porige mit anorganischem Farbstoff durchsetzte Schicht aus Titandioxid ausgebildet ist, daß auf der rückwärtigen Oberfläche der Anode eine als Kathode dienende Gegenelektrode anliegt und daß die Rückwand biegesteif ausgebildet ist.

Im Unterschied zu den aus dem Stand der Technik bekannten Ausgestaltungen einer derartigen photoelektrochemischen Zelle ist der zur photoelektrochemischen Reaktion erforderliche Farbstoff nicht auf der Oberfläche des Titandioxid-Substrats angeordnet, sondern das Titandioxid-Substrat ist gleichförmig mit dem jeweiligen Farbstoff durchsetzt, so daß die Lichtausbeute, d.h. die Absorptionsfähigkeit für sichtbares Licht, also Sonnenlicht, deutich erhöht wird.

In vorteilhafter Weiterbildung der Erfindung ist vorgesehen, daß mehrere durch Leitungswege miteinander verbundene Anoden vorgesehen sind, denen jeweils Kathoden zugeordnet sind und daß die so gebildeten Elemente elektrisch in Reihe geschaltet sind. Dabei dient vorteilhafterweise die transparente elektrisch leitende Oxidschicht als Leitungsweg.

Gemäß einer bevorzugten Ausführungsform der Erfindung ist dabei vorgesehen, daß die transparente elektrisch leitende Oxidschicht (TLO) planmäßig in Abschnitte unterteilt ist, welche elektrisch voneinander getrennt sind und deren Größe auf die jeweils zugeordnete Anode angepaßt ist.

Dabei ist entsprechend der Reihenschaltung vorgesehen, daß jeder Abschnitt der TLO mit der zugeordneten Anode sowie mit der Kathode eines anderen Elements elektrisch leitend verbunden ist.

Eine weitere bevorzugte Ausgestaltung der Erfindung sieht vor, daß die als Kathode dienende Gegenelektrode aus elektrisch leitendem organischem Werkstoff besteht. Dies hat insbesondere den Vorteil kostengünstiger Herstellbarkeit, wenn als elektrisch leitender organischer Werkstoff ein mit elektrisch leitfähigen Partikeln durchsetzter Kunststoff verwendet wird. Ein solcher Kunststoff, der mittels Zugaben von Ruß, C-Fasern, Siliziumcarbid oder elektrisch leitfähigen anorganischen Substanzen seine Leitfähigkeit erhält, ist vergleichsweise einfach herstellbar, gut handhabbar bei der Verarbeitung und im Gebrauch sowie aufgrund des vergleichweise geringen spezifischen Gewichts auch günstig für die Handhabung einer solcherart gestalteten photoelektrochemischen Zelle.

Als Kunststoff können entweder Duroplaste, z.B. Epoxid-Formstoff oder ungesättigter Polyester-Formstoff, als auch Thermoplaste vorgesehen sein.

Die Kontaktierung, d.h. die elektrisch leitende Verbindung, der Gegenelektrode mit der TLO-Schicht ist in weiterer Ausgestaltung der Erfindung mittels leitfähiger Klebverbindung vorgesehen. Eine solche Klebverbindung kann sowohl mittels Schmelzkleber mit Zusatz leitfähiger Partikel, wie vorstehend bereits erläutert, oder im Falle, daß die Gegenelektrode aus elektrisch leitfähigem Thermoplast besteht, durch örtliches Aufschmelzen erfolgen.

Für die Herstellung einer solchen photoelektrochemischen Zelle ist prinzipiell jedes Glas, welches durchlässig ist für sichtbares Licht, geeignet. Als vorteilhaft jedoch erweist, wenn die Glasplatte aus Fe-armem Glas, also Weißglas, vorgesehen ist.

Diese und weitere vorteilhafte Ausgestaltungen sind Gegenstand der Unteransprüche.

Anhand eines in den Figuren dargestellten Ausführungsbeispieles sollen die Erfindung, besondere Vorteile und vorteilhafte Ausgestaltungen der Erfindung näher erläutert und beschrieben werden.

Es zeigen:
- Figur 1: den schematischen Aufbau eines Elements einer erfindungsgemäßen Zelle im Längsschnitt,
- Figur 2: eine perspektivische Schnittansicht einer aus mehreren Elementen gebildeten erfindungsgemäßen Zelle.

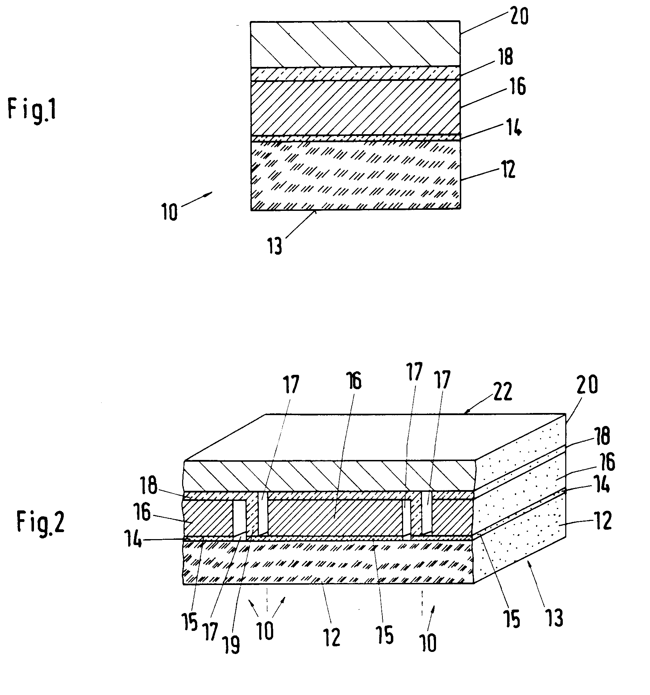

In Figur 1 ist im Längsschnitt der Aufbau eines Elements 10 einer photoelektrochemischen Zelle gemäß der Erfindung dargestellt. Eine solche Zelle ist aus mehreren Schichten zusammengesetzt, welche auf einer in der Darstellung unten angeordneten Glasplatte 12 aufgebaut werden.

Die nach unten weisende Längsseite der Glasplatte 12 bildet die Frontseite 13 des photoelektrochemischen Elements 10. Auf der der Frontseite 13 abgewandten Seite ist eine transparente elektrisch leitende Oxidschicht 14 aufgebracht, beispielsweise mittels Aufdampfen, auf welcher eine als Anode 16 dienende weitere Schicht aufgelegt ist. Diese Anode 16 besteht entsprechend der Erfindung aus einem gleichförmig durchsetzten Gemisch von Titandioxidpulver und Farbstoff, welches auf die transparente elektrisch leitende Oxidschicht 14 aufgetragen und unter Wärmezufuhr stabilisiert wird.

An diese als Anode 14 dienende Substratschicht schließt sich eine weitere als Kathode oder Gegenelektrode 18 dienende Leitschicht an, die an einer Rückwand 20 an ihrer der Frontseite 13 abgewandten Oberfläche flächig anliegt.

Die in Figur 1 dargestellten Schichtdicken sind nicht maßstäblich, geben jedoch tendenziell das Größenverhältnis der einzelnen Schichtdicken zueinander wieder. Während die Schichtdicke der transparenten elektrisch leitenden Oxidschicht 14 etwa 1 µm beträgt, beträgt die Schichtdicke der als Anode 16 dienenden TiO₂-Farbstoff-Substrat-Schicht etwa 10 bis 20 µm. Die Schichtdicke der Gegenelektrode 18 richtet sich nach der jeweils erzielbaren Leitfähigkeit, die sowohl von der Art der in die Matrix aus organischem Werkstoff, vorzugsweise Kunststoff, eingelagerten leitenden Partikel als auch deren Mengenanteil bzw. Verteilung abhängt. Demgemäß kann die Schichtdicke der Kathode 18 bis ca. 1 mm betragen. Die Dicke der Rückwand 20 hängt ab von der Steifigkeit des verwendeten Materials, damit die in Figur 1 schematisch dargestellte Anordnung nicht infolge unerwünschter Verformung Schaden nimmt.

In Figur 2 ist in perspektivischer Schnittansicht eine aus mehreren Elementen 10 gebildete photoelektrochemische Zelle 22 dargestellt. Die Zelle 22 ist durch Reihenschaltung mehrerer nebeneinander angeordneter Elemente 10, gekennzeichnet mittels Strichlinien gebildet, die in Form einer Reihenschaltung miteinander verbunden sind. Dabei ist die transparente elektrisch leitende Oxidschicht 14 in verschiedene Abschnitte 15 unterteilt. Jeder Abschnitt 15 ist elektrisch leitend mit der zugeordneten, darüber befindlichen Anode 16 sowie mit einem Verbindungsleiter 19 der Kathode eines benachbarten Elements 10 verbunden. Dieser Verbindungsleiter 19 ist einstückig mit der Kathode oder Gegenelektrode 18 verbunden, welche zu diesem Zweck über die Anode 16, an welcher sie dicht anliegt, übersteht. Um den Verbindungsleiter 19 eindeutig gegenüber den Anoden 16 elektrisch zu isolieren, sind die Elemente 10 jeweils durch einen Spalt 17 getrennt, durch welchen der Verbindungsleiter 19 mit Abstand zu den Elektroden 16 mittig durchgreift.

Die Breite einer solchen Zelle beträgt etwa 1 bis 2 cm, während die Länge etwa 100 cm beträgt.

Die Wirkungsweise der so beschaffenen photoelektrochemischen Zelle 22 beruht in bekannter Weise darauf, daß Sonnenlicht auf die in Figur 2 nach unten weisende Frontseite 13 fällt und so den bekannten photoelektrochemischen Prozeß einleitet.

## Patentansprüche

1. Photoelektrochemische Zelle, insbesondere Solarzelle, mit wenigstens einer Elektrode, die auf einer Glasplatte angeordnet ist, welche Glasplatte die Frontseite bildet, und mit einer elektrisch nichtleitenden Rückwand, dadurch gekennzeichnet, daß zwischen der Glasplatte (12) und der Elektrode (16) eine transparente, elektrisch leitende Oxidschicht (14) angeordnet ist, daß die Elektrode (16) als Anode dient und als porige mit anorganischem Farbstoff durchsetzte Schicht aus Titandioxid ausgebildet ist, daß auf der rückwärtigen Oberfläche der Anode (16) eine als Kathode (18) dienende Gegenelektrode anliegt und daß die Rückwand (20) biegesteif ausgebildet ist.

2. Zelle nach Anspruch 1, dadurch gekennzeichnet, daß mehrere durch Leitungswege (15) miteinander verbundene Anoden (16) vorgesehen sind, denen jeweils Kathoden (18) zugeordnet sind.

3. Zelle nach Anspruch 1 oder 2, dadurch gekennzeichnet, daß mehrere aus Anoden (16) und Kathoden (18) gebildeten Elemente (10) elektrisch in Reihe geschaltet sind.

4. Zelle nach Anspruch 2 oder 3, dadurch gekennzeichnet, daß die transparente elektrisch leitende Oxidschicht (14) als Leitungsweg (15) dient.

5. Zelle nach Anspruch 4, dadurch gekennzeichnet, daß die transparente elektrisch leitende Oxidschicht (14) planmäßig in Abschnitte (15) unterteilt ist, die gegeneinander isoliert sind und deren Größe auf die zugeordnete Anode (16) angepaßt ist.

6. Zelle nach Anspruch 5, dadurch gekennzeichnet, daß jeder Abschnitt (15) der elektrisch leitenden Oxidschicht (14) mit der zugeordneten Anode (16) und der Kathode (18) eines anderen Elements (10) elektrisch leitend verbunden ist.

7. Zelle nach einem der vorherigen Ansprüche, dadurch gekennzeichnet, daß die als Kathode (18) dienende Gegenelektrode aus elektrisch leitendem organischem Werkstoff besteht.

8. Zelle nach Anspruch 7, dadurch gekennzeichnet, daß der elektrisch leitende Werkstoff ein mit elektrisch leitfähigen Partikeln durchsetzter Kunststoff ist.

9. Zelle nach Anspruch 8, dadurch gekennzeichnet, daß als elektrisch leitende Partikel Ruß, C-Fasern, Siliziumcarbid oder elektrisch leitfähige anorganische Substanzen vorgesehen sind.

10. Zelle nach einem der vorherigen Ansprüche, dadurch gekennzeichnet, daß die Gegenelektrode (18) aus Duroplast gebildet ist.

11. Zelle nach Anspruch 10, dadurch gekennzeichnet, daß die Gegenelektrode (18) aus Epoxid-Formstoff gebildet ist.

12. Zelle nach Anspruch 10, dadurch gekennzeichnet, da die Gegenelektrode (18) aus ungesättigtem Polyester-Formstoff gebildet ist.

13. Zelle nach einem der vorherigen Ansprüche 1 bis 9, dadurch gekennzeichnet, daß die Gegenelektrode (18) aus Thermoplast besteht.

14. Zelle nach einem der vorherigen Ansprüche, dadurch gekennzeichnet, daß zur Kontaktierung der Gegenelektrode (18) mit der transparenten elektrisch leitenden Oxidschicht (14) eine leitfähige Klebeverbindung vorgesehen ist.

15. Zelle nach Anspruch 14, dadurch gekennzeichnet, daß für die leitfähige Klebeverbindung ein Schmelzkleber mit Rußzusatz vorgesehen ist.

16. Zelle nach Anspruch 13 und 14, dadurch gekennzeichnet, daß die leitfähige Klebeverbindung durch örtliches Anschmelzen gebildet ist.

17. Zelle nach einem der vorherigen Ansprüche, dadurch gekennzeichnet, daß es sich um eine Farbstoff-Solarzelle handelt.

18. Zelle nach einem der vorherigen Ansprüche, dadurch gekennzeichnet, daß die die Frontseite bildende Glasplatte (12) aus eisenarmem Weißglas besteht.
